# EUROPEAN PATENT SPECIFICATION

(11) **EP 0 913 867 B1**
(45) Date of publication and mention of the grant of the patent: **11.07.2012**
(21) Application number: 98402702.9
(22) Date of filing: 29.10.1998
(51) Int. Cl.: H01L 27/108, G11C 11/405

(54) **DRAM cell with separate read and write transistors**
DRAM-Zelle mit separaten Schreib- und Lesetransistoren
Cellule DRAM avec des transistors d'écriture et de lecture séparés

(30) Priority: 29.10.1997 JP 29755997; 20.02.1998 JP 3869098; 03.03.1998 JP 5034898; 29.10.1997 JP 29756097; 05.02.1998 JP 2465198; 05.02.1998 JP 2465298
(43) Date of publication of application: 06.05.1999
(73) Proprietor: Sony Corporation, Tokyo (JP)
(72) Inventor: Mukai, Mikio, Shinagawa-ku, Tokyo (JP); Hayashi, Yutaka, Shinagawa-ku, Tokyo (JP)
(74) Representative: Thévenet, Jean-Bruno

(56) References cited:
- US-A- 4 612 629

## Description

### Background of the Invention and Related Art Statement

The present invention relates to a semiconductor memory cell including multiple transistors or a semiconductor memory cell including multiple transistors physically merged into one unit.

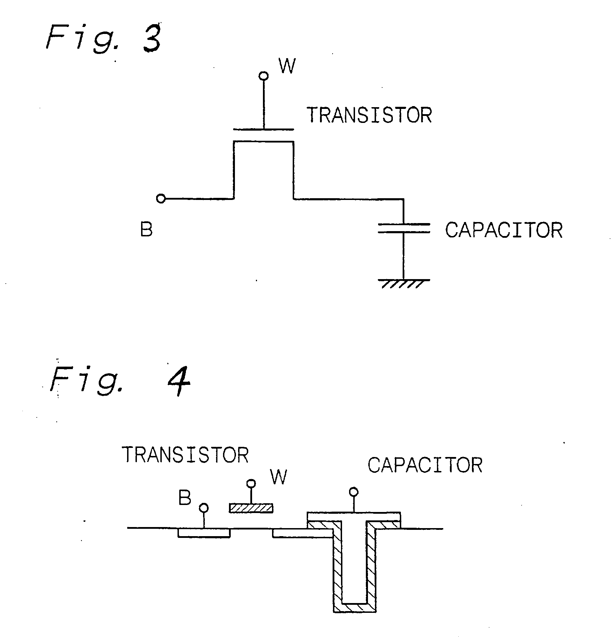

As a high-density semiconductor memory cell, there has been made available a dynamic semiconductor memory cell that can be referred to as a single-transistor semiconductor memory cell including one transistor and one capacitor shown in Fig. 3. In the above semiconductor memory cell, an electric charge stored in the capacitor is required to be large enough to generate a sufficiently large voltage change on a bit line. However, as the planar dimensions of the semiconductor memory cell are reduced, the capacitor formed in a parallel planar shape decreases in size, which causes a new problem that, when information which is stored as an electric charge in the capacitor of the semiconductor memory cell is read out, the read-out information is buried in noise, or that only a small voltage change is generated on the bit line since the stray capacitance of the bit line increases for every new generation of the semiconductor memory cell. As means for solving the above problems, there has been proposed a dynamic semiconductor memory cell having a trench capacitor cell structure shown in Fig. 4 or a stacked capacitor cell structure. Since, however, the fabrication-related technology has its own limits on the depth of the trench (or the groove) or the height of the stack, the capacitance of the capacitor is also limited. For this reason, dynamic semiconductor memory cells having the above structures are said to be suffered from the above mentioned limitation for the dimension beyond the low sub-micron rules unless expensive new materials are introduced for the capacitor.

In the planar dimensions smaller than those of the low sub-micron rule, the transistor constituting the semiconductor memory cell also has problems of deterioration of the drain breakdown voltage and drain-to-source punchthrough voltage. There is therefore a large risk that current leakage arises even if the voltage applied to the semiconductor memory cell is still within a predetermined range. When a semiconductor memory cell is made smaller in size, therefore, it is difficult to normally operate the semiconductor memory cell having a conventional transistor structure.

For overcoming the above limit problems of the capacitor, the present applicant has proposed a semiconductor memory cell comprising two transistors or two transistors physically merged into one unit, as is disclosed in Japanese Patent Application No. 246264/1993 (Japanese Patent Laid-open No. 99251/1995), corresponding to U.S. Patent No. 5,428,238. The semiconductor memory cell shown in Figs. 15 (A) and 15 (B) of Japanese Patent Laid-Open No. 99251/1995 comprises a first semi-conductive region SC1 of a first conductivity type formed in a surface region of a semiconductor substrate or formed on an insulating substrate, a first conductive region SC2 formed in a surface region of the first semi-conductive region SC1 so as to form a rectifier junction together with the first semi-conductive region SC1, a second semi-conductive region SC3 of a second conductivity type formed in a surface region of the first semi-conductive region SC1 and spaced from the first conductive region SC2, a second conductive region SC4 formed in a surface region of the second semi-conductive region SC3 so as to form a rectifier junction together with the second semi-conductive region SC3, and a conductive gate G formed on a barrier layer so as to bridge the first semi-conductive region SC1 and the second conductive region SC4 and so as to bridge the first conductive region SC2 and the second semi-conductive region SC3, the conductive gate G being connected to a first memory-cell-selecting line, the first conductive region SC2 being connected to a write-in information setting line, and the second conductive region SC4 being connected to a second memory-cell-selecting line.

The first semi-conductive region SC1 (functioning as a channel forming region Ch2), the first conductive region SC2 (functioning as one source/drain region), the second semi-conductive region SC3 (functioning as the other source/drain region) and the conductive gate G constitute a switching transistor TR2. On the other hand, the second semi-conductive region SC3 (functioning as a channel forming region Ch1), the first semi-conductive region SC1 (functioning as one source/drain region), the second conductive region SC4 (functioning as the other source/drain region) and the conductive gate G constitute an information storing transistor TR1.

The semiconductor memory cell shown in Figs. 12 (A) and 13 of Japanese Patent Laid-Open No. 99251/1995 comprises a first conductive region SC1 of a first conductivity type formed in a p-type well (a fourth conductive region) SC4, a second conductive region SC2 formed in a surface region of the fourth conductive region SC4 so as to form a rectifier junction together with the fourth conductive region SC4, a third conductive region SC3 of a second conductivity type formed in a surface region of the first conductive region SC1 and spaced from the second conductive region SC2, and a conductive gate G formed on a barrier layer so as to bridge the first conductive region SC 1 and the second conductive region SC2 and so as to bridge the third conductive region SC3 and the fourth conductive region SC4, the conductive gate G being connected to a first memory-cell-selecting line, the second conductive region SC2 being connected to a write-in information setting line, and the third conductive region SC3 being connected to a second memory-cell-selecting line. The third conductive region SC3 is constituted of a p-type semi-conductive region SC3p and a metal layer SC3s which is adjacent to the p-type semi-conductive region SC3p to form a Schottky junction. The regions SC3p and SC3s are formed in a surface region of the first conductive region SC1.

The first conductive region SC1 (functioning as a channel forming region Ch2), the fourth conductive region SC4 (functioning as one source/drain region), the third conductive region SC3 (functioning as the other source/drain region) and the conductive gate G constitute a switching transistor TR2. On the other hand, the fourth conductive region SC4 (functioning as a channel forming region Ch1), the first conductive region SC1 (functioning as one source/drain region), the second conductive region SC2 (functioning as the other source/drain region) and the conductive gate G constitute an information storing transistor TR1. The metal layer SC3s in itself does not constitute the source/drain region of the switching transistor TR2.

When information is written in the above semiconductor memory cells, the switching transistor TR2 is brought into an on-state. As a result, the information is stored in the channel forming region Ch1 of the information storing transistor TR1 as a potential or as an electric charge. When the information is read out, a threshold voltage of the information storing transistor TR1 seen from the conductive gate G varies, depending upon the potential or the electric charge stored in the channel forming region Ch1 of the information storing transistor TR1. Therefore, when the information is read out, the storage state of the information storing transistor TR1 can be judged from the magnitude of a channel current (including a zero magnitude) by applying a properly selected potential to the conductive gate G. The information is read out by detecting the operation state of the information storing transistor TR1.

That is, in the semiconductor memory cell shown in Figs. 15 (A) and 15 (B) of Japanese Patent Laid-Open No. 99251/1995, when the information is read out, the information storing transistor TR1 is brought into an on-state or an off-state, depending upon the information stored therein. Since the second conductive region SC4 is connected to the second memory-cell-selecting line, a large current or a small current may flow in the information storing transistor TR1, depending upon the stored information ("0" or "1"). In this way, the information stored in the semiconductor memory cell can be read out by utilising the information storing transistor TR1. However, when the information is read out, the semiconductor memory cell has no mechanism for controlling the current which flows through the first semi-conductive region SC1 sandwiched by the first conductive region SC2 and the second semi-conductive region SC3. Therefore, when the information stored in the information storing transistor TR1 is detected with the conductive gate G, only a small margin of the current which flows between the first semi-conductive region SC1 and the second conductive region SC4 is obtained, which causes a problem that the number of the semiconductor memory cells connected to the second memory-cell-selecting line (a bit line) is limited.

Further, since the information storing transistor TR1 and the switching transistor TR2 are formed in the same main surface of the semiconductor substrate, the semiconductor memory cell has problems that it is large in size and that a margin in the manufacturing process of the semiconductor memory cell is small. The semiconductor memory cell may have a configuration in which the information storing transistor TR1 and the switching transistor TR2 are merged into one unit. As a result, the information storing transistor TR1 and the switching transistor TR2 may be formed in an area equivalent to that required for one conventional transistor. However, when the integration density of an integrated circuit is increased, the area of the integrated circuit increases proportional to the number of the semiconductor memory cells. As a result, it is difficult to fully satisfy the demand for manufacturing the semiconductor memory cell with a higher integration density.

Document US 4612629 further discloses a dynamic RAM memory cell comprising two transistors, one JFET and one diode.

### OBJECT AND SUMMARY OF THE INVENTION

It is therefore an object of the present invention to provide a semiconductor memory cell which attains the stable performance of transistors, a large window (current difference) for reading out information stored therein to assure consistent read-out/write-in and permits smaller dimensions or to provide a logic compatible memory cell.

Further, it is an object of the present invention to provide a semiconductor memory cell having a compact memory cell structure.

Further, it is an object of the present invention to provide a semiconductor memory cell comprising 3 transistors, viz. transistor for read-out, a transistor for write-in and a junction-field-effect transistor for current control, and a diode, wherein the transistor for read-out and the transistor for write-in are merged into one unit.

These objects are attained with a semiconductor memory cell as defined in the appended claims, which define the invention.

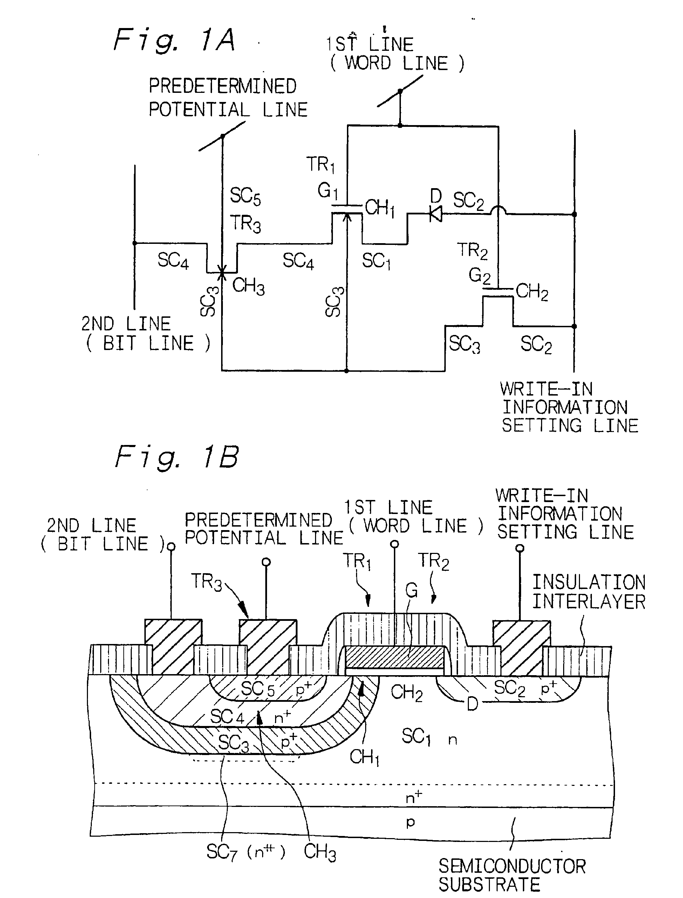

As shown in a principle drawing of Fig. 1A, for achieving the above object, according to a first aspect of the present invention, there is provided a semiconductor memory cell comprising a first transistor of a first conductivity type for read-out TR1, a second transistor of a second conductivity type for write-in TR2 and a junction-field-effect transistor of the first conductivity type for current control TR3,
said semiconductor memory cell having;
(1) a first semi-conductive region SC1 of the first conductivity type,
(2) a second semi-conductive or conductive region SC2 formed in a surface region of the first region SC1, said second region SC2 forming a rectifier junction together with the first region SC1,
(3) a third semi-conductive region SC3 of the second conductivity type formed in a surface region of the first region SC1 and spaced from the second region SC2,
(4) a fourth semi-conductive region SC4 of the first conductivity type formed in a surface region of the third region SC3,
(5) a fifth semi-conductive or conductive region SC5 formed in a surface region of the fourth region SC4, said fifth region SC5 forming a rectifier junction together with the fourth region SC4, and
(6) a gate portion G shared by the first transistor TR1 and the second transistor TR2, and formed on a barrier layer so as to bridge the first region SC 1 and the fourth region SC4 and so as to bridge the second region SC2 and the third region SC3,
wherein;
(A-1) one source/drain region of the first transistor TR1 is constituted of the surface region of the fourth region SC4,
(A-2) the other source/drain region of the first transistor TR1 is constituted of the surface region of the first region SC1 sandwiched by the second region SC2 and the third region SC3,
(A-3) a channel forming region CH1 of the first transistor TR1 is constituted of the surface region of the third region SC3 sandwiched by the surface region of the first region SC1 and the surface region of the fourth region SC4,
(B-1) one source/drain region of the second transistor TR2 is constituted of the second region SC2,
(B-2) the other source/drain region of the second transistor TR2 is constituted of the surface region of the third region SC3 constituting the channel forming region CH1 of the first transistor TR1,
(B-3) a channel forming region CH2 of the second transistor TR2 is constituted of the surface region of the first region SC1 constituting the other source/drain region of the first transistor TR1,
(C-1) gate regions of the junction-field-effect transistor TR3 are constituted of the fifth region SC5 and a portion of the third region SC3 facing the fifth region SC5,
(C-2) a channel region CH3 of the junction-field-effect transistor TR3 is constituted of part of the fourth region SC4 sandwiched by the fifth region SC5 and said portion of the third region SC3,
(C-3) one source/drain region of the junction-field-effect transistor TR3 is constituted of a portion of the fourth region SC4 extending from one end of the channel region CH3 of the junction-field-effect transistor TR3 and constituting one source/drain region of the first transistor TR1,
(C-4) the other source/drain region of the junction-field-effect transistor TR3 is constituted of a portion of the fourth region SC4 extending from the other end of the channel region CH3 of the junction-field-effect transistor TR3,
(D) the gate portion G is connected to a first memory-cell-selecting line,
(E) a diode D is formed between the first region SC1 and the second region SC2, and the first region SC1 is connected to a write-in information setting line through the diode D,
(F) the second region SC2 is connected to the write-in information setting line,
(G) the portion of the fourth region SC4 constituting the other source/drain region of the junction-field-effect transistor TR3 is connected to a second memory-cell-selecting line, and
(H) the fifth region SC5 is connected to a predetermined potential line.

The meaning of the term "sandwiched by" is equivalent to that of the term "interposed between", in the specification and the claims. In the drawings, the first memory-cell-selecting line is referred to as "1ST LINE", the second memory-cell-selecting line is referred to as "2ND LINE".

In the semiconductor memory cell according to the first aspect of the present invention, the configuration in which the second region SC2 is connected to the write-in information setting line includes a configuration in which the second region SC2 and part of the write-in information setting line are fabricated in common. The configuration in which the fifth region SC5 is connected to the predetermined potential line includes a configuration in which the fifth region SC5 and part of the predetermined potential line are fabricated in common.

The semiconductor memory cell according to the first aspect of the present invention can be formed in a surface region of a semiconductor substrate, formed on an insulating layer or an insulator formed on a semiconductor substrate or a supporting substrate, formed in a well of the first conductivity type in a semiconductor substrate, or formed on an electric insulator, and is preferably formed in a well of the first conductivity type or formed on an insulator including an insulating layer and an insulating substrate, for preventing alpha-particle or neutron induced soft error.

In the semiconductor memory cell according to the first aspect of the present invention, a region SC7 containing a high concentration of an impurity having the first conductivity type is preferably formed under the third region SC3, for increasing a potential or an electric charge stored in the channel forming region CH1 of the first transistor TR1.

Each of the second region SC2 and the fifth region SC5 in the semiconductor memory cell according to first aspect of the present invention may be constituted of a silicide, a metal or a metal compound, and is preferably constituted of semiconductor.

In the semiconductor memory cell according to the first aspect of the present invention, each gate portion of the first transistor TR1 and the second transistor TR2 is connected to the first memory-cell-selecting line. It is therefore sufficient to provide one first memory-cell-selecting line, so that the chip area can be decreased.

In the semiconductor memory cell according to the first aspect of the present invention, the third region SC3 functioning as (or corresponding to) the other source/drain region of the second transistor TR2 functions as (or corresponds to) the channel forming region CH1 of the first transistor TR1. The first region SC1 functioning as (or corresponding to) the channel forming region CH2 of the second transistor TR2 and functioning as (or corresponding to) the other source/drain region of the first transistor TR1 is connected to the write-in information setting line. And, when the on- and off-states of the first transistor TR1 and the second transistor TR2 can be controlled by properly selecting a potential in the first memory-cell-selecting line. That is, when the potential of the first memory-cell-selecting line is set at a potential as high enough to bring the second transistor TR2 into an on-state at a write-in time, the second transistor TR2 is brought into an on-state, and whereby an electric charge is charged or accumulated in a capacitor formed between the first region SC1 and the third region SC3 in the second transistor TR2 depending upon the potential of the write-in information setting line. As a result, the information is stored in the channel forming region CH1 (the third region SC3) of the first transistor TR1 as a potential difference between the first region SC 1 and the third region SC3 or as an electric charge. When the information is read out, the potential of the first region SC1 is set at a read-out potential, and in the first transistor TR1, the potential or the electric charge (the information) stored or accumulated in the channel forming region CH1 of the first transistor TR1 is converted to a potential difference between the third region SC3 (functioning as or corresponding to the channel forming region CH1) and the fourth region SC4 (functioning as or corresponding to the source/drain region), or to an electric charge. As a result, the threshold voltage of the first transistor TR1 seen from the gate region G varies depending upon the above potential difference or electric charge (the information). When the information is read out, therefore, the on/off operation of the first transistor TR1 can be controlled by applying a properly selected potential to the gate portion G. That is, the information can be read out by detecting the operation state of the first transistor TR1.

Moreover, the semiconductor memory cell according to the first aspect of the present invention is provided with the junction-field-effect transistor TR3 in addition to the first transistor TR1 and the second transistor TR2. Since the on/off operation of the junction-field-effect transistor TR3 is controlled when the information is read out, a large margin can be assured for the current which flows between the first region SC1 and the fourth region SC4. As a result, the number of semiconductor memory cells that can be connected to the second memory-cell-selecting line is hardly limited, and further, the information holding time (retention time) of the semiconductor memory cell can be increased.

The semiconductor memory cell of the present invention can be formed in a surface region of a semiconductor substrate, formed on an insulating layer or an insulator formed on a semiconductor substrate or a supporting substrate, formed in a well formed in a semiconductor substrate, or formed on an electric insulator, and is preferably formed in a well or formed on an insulator including an insulating layer and an insulating substrate, or has an SOI structure or a TFT structure, for preventing alpha-particle or neutron induced soft error.

The channel forming region or the channel region can be formed from a material such as silicon or GaAs by using a known process. Each gate region can be formed of a material such as a metal; GaAs doped with an impurity at a high concentration; silicon, amorphous silicon, polysilicon a silicide doped with an impurity; or a polyside, by using a known process. The barrier layer can be formed of a material such as SiO2, Si3N4, Al2O3 or GaAlAs by using a known process. Each region can be formed of silicon, amorphous silicon or polysilicon doped with an impurity, a silicide, a two-layer structure having a silicide layer and a semi-conductive layer, or GaAs doped with an impurity at a high concentration by using a known process, depending upon characteristics required. The semi-conductive layer can be formed of a material such as silicon or GaAs.

The junction-field-effect transistor (JFET) in the semiconductor memory cell of the present invention can be formed by
(X) optimising the distance between the facing gate regions of the junction-field-effect transistor, that is, the thickness of the channel region, and
(Y) optimising impurity concentrations of the facing gate regions and the channel region of the junction-field-effect transistor. It should be noted that if neither the distance between the facing gate regions (the thickness of the channel region CH3) of the junction-field-effect transistor, nor the impurity concentrations of the facing gate regions and the channel region of the junction-field-effect transistor are optimised, the depletion layer will not be widened, making it impossible to bring the junction-field-effect transistor into an on-state or an off-state. These optimisations need to be carried out by computer simulation or experiments.

The semiconductor memory cell of the present invention retains the information as a potential, a potential difference or an electric charge, while leak current caused by junction leak, etc., attenuates them sooner or later. It is therefore necessary to refresh it, and the semiconductor memory cell is operated like DRAM.

### BRIEF DESCRIPTION OF THE DRAWINGS

The present invention will be explained in detail with reference to drawings hereinafter.
Figs. 1A and 1B are a principle drawing and a schematic partial cross-sectional view of a semiconductor memory cell in Example 1, respectively illustrating the present invention,
Figs. 2A and 2B are schematic partial cross-sectional views of modifications of the semiconductor memory cell in Example 1.
Fig. 3 schematically shows a conventional single-transistor memory cell.
Fig. 4 schematically shows a conventional memory cell having a trench capacitor structure.

### DESCRIPTION OF THE PREFERRED EMBODIMENTS

### Example 1

Example 1 is directed to the semiconductor memory cell according to the first aspect of the present invention. For example, as Fig. 1A shows its principle drawing and as Fig. 1B shows its schematic partial cross-sectional view, the semiconductor memory cell of Example 1 comprises a first transistor of a first conductivity type (e.g., n-type) for read-out TR1, a second transistor of a second conductivity type (e.g., p-type) for write-in TR2, a junction-field-effect transistor of a first conductivity type (e.g., n-type) for current control TR3 and a diode D. In Example 1, the first transistor TR1 and the second transistor TR2 are merged into one unit. That is, the semiconductor memory cell of Example 1 approximately occupies an area which one transistor occupies.

The semiconductor memory cell of Example 1 has;
(1) a first semi-conductive region SC1 of the first conductivity type (for example, n-type),
(2) a second semi-conductive region SC2 of the second conductivity type (for example, p+-type) opposite to the first conductivity type, or a second conductive region SC2 formed of a silicide, a metal or a metal compound, said second region SC2 being formed in a surface region of the first region SC1 and forming a rectifier junction together with the first region SC1,
(3) a third semi-conductive region SC3 of the second conductivity type (for example, p+-type), formed in a surface region of the first region SC1 and spaced from the second region SC2,
(4) a fourth semi-conductive region SC4 of the first conductivity type (for example, n+-type), formed in a surface region of the third region SC3,
(5) a fifth semi-conductive region SC5 of the second conductivity type (for example, p+-type), or a fifth conductive region SC5 formed of a silicide, a metal or a metal compound, said fifth region SC5 being formed in a surface region of the fourth region SC4 and forming a rectifier junction together with the fourth region SC4, and
(6) a gate portion G shared by the first transistor TR1 and the second transistor TR2, and formed on a barrier layer so as to bridge the first region SC1 and the fourth region SC4 and so as to bridge the second region SC2 and the third region SC3.

Concerning the first transistor TR1;
(A-1) one source/drain region is constituted of the surface region of the fourth region SC4,
(A-2) the other source/drain region is constituted of the surface region of the first region SC1 sandwiched by (or interposed between) the second region SC2 and the third region SC3, and
(A-3) a channel forming region CH1 is constituted of the surface region of the third region SC3 sandwiched by (or interposed between) the surface region of the first region SC1 and the surface region of the fourth region SC4.

Concerning the second transistor TR2;
(B-1) one source/drain region is constituted of the second region SC2,
(B-2) the other source/drain region is constituted of the surface region of the third region SC3 constituting the channel forming region CH1 of the first transistor TR1, and
(B-3) a channel forming region CH2 is constituted of the surface region of the first region SC1 constituting the other source/drain region of the first transistor TR1.

Further, concerning the junction-field-effect transistor TR3;
(C-1) gate regions are constituted of the fifth region SC5 and a portion of the third region SC3 facing the fifth region SC5,
(C-2) a channel region CH3 is constituted of part of the fourth region SC4 sandwiched by (or interposed between) the fifth region SC5 and said portion of the third region SC3,
(C-3) one source/drain region is constituted of a portion of the fourth region SC4 extending from one end of the channel region CH3 of the junction-field-effect transistor TR3 and constituting one source/drain region of the first transistor TR1, and
(C-4) the other source/drain region is constituted of a portion of the fourth region SC4 extending from the other end of the channel region CH3 of the junction-field-effect transistor TR3.

The junction-field-effect transistor TR3 in the semiconductor memory cell of Example 1 can be formed by
(X) optimising the distance (thickness of the channel region CH3) between the facing gate regions (the fifth region SC5 and the portion of the third region SC3 facing the fifth region SC5) of the junction-field-effect transistor TR3, and
(Y) optimising impurity concentrations of the facing gate regions (the fifth region SC5 and the portion of the third region SC3 facing the fifth region SC5) and the channel region CH3 (specifically, the fourth region SC4) of the junction-field-effect transistor TR3.

In Example 1, the semiconductor memory cell (specifically, the first region SC1) is formed in a well of the first conductivity type (for example, n-type) in a p-type semiconductor substrate.

In the semiconductor memory cell of Example 1, the gate portion G is connected to a first memory-cell-selecting line (for example, a word line); a diode D is formed between the first region SC1 and the second region SC2; the first region SC 1 is connected to a write-in information setting line through the diode D; the second region SC2 is connected to the write-in information setting line; the portion of the fourth region SC4 constituting the other source/drain region of the junction-field-effect transistor TR3 is connected to a second memory-cell-selecting line (for example, a bit line); and the fifth region SC5 is connected to a predetermined potential line.

When a region SC7 containing a high concentration of an impurity having the first conductivity type (for example, n++-type) is formed between the first region SC1 and the third region SC3 in the semiconductor memory cell of Example 1, a potential or an electric charge stored in the channel forming region CH2 of the first transistor TR1 can be increased.

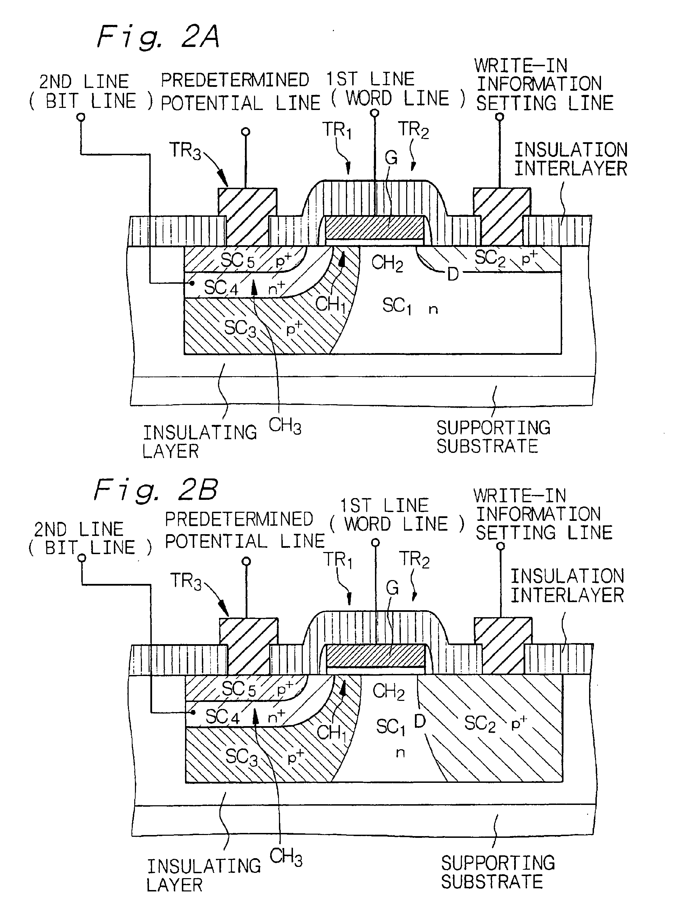

Figs. 2A and 2B show schematic partial cross-sectional views of modifications of the semiconductor memory cell in Example 1. As shown in Fig. 2A or Fig. 2B, the semiconductor memory cell having the same configuration as the semiconductor memory cell shown in Fig. 1B is formed in a semi-conductive layer surrounded with an insulating layer formed on a supporting substrate. The semiconductor memory cell shown in Fig. 2A has the same configuration as the semiconductor memory cell shown in Fig. 2B, except the depth of the second region SC2.

## Claims

1. A semiconductor memory cell comprising a first transistor (TR1) of a first conductivity type for read-out, a second transistor (TR2) of a second conductivity type for write-in and a junction-field-effect transistor (TR3) of the first conductivity type for current control,
said semiconductor memory cell having;
(1) a first semi-conductive region (SC1) of the first conductivity type,
(2) a second semi-conductive (SC2) or conductive region formed in a surface region of the first region (SC1), said second region (SC2) forming a rectifier junction together with the first region (SC1),
(3) a third semi-conductive region (SC3) of the second conductivity type formed in a surface region of the first region (SC1) and spaced from the second region (SC2),
(4) a fourth semi-conductive region (SC4) of the first conductivity type formed in a surface region of the third region (SC3),
(5) a fifth semi-conductive (SC5) or conductive region formed in a surface region of the fourth region (SC4), said fifth region (SC5) forming a rectifier junction together with the fourth region (SC4), and
(6) a gate portion (G) shared by the first transistor (TR1) and the second transistor (TR2), and formed on a barrier layer so as to bridge the first region (SC1) and the fourth region (SC4) and so as to bridge the second region (SC2) and the third region (SC3),
wherein;
(A-1) one source/drain region of the first transistor (TR1) is constituted of the surface region of the fourth region (SC4),
(A-2) the other source/drain region of the first transistor (TR1) is constituted of the surface region of the first region (SC1) sandwiched by the second region (SC2) and the third region (SC3),
(A-3) a channel forming region (CH1) of the first transistor (TR1) is constituted of the surface region of the third region (SC3) sandwiched by the surface region of the first region (SC1) and the surface region of the fourth region, (B-1) one source/drain region of the second transistor (TR2) is constituted of the second region (SC2),
(B-2) the other source/drain region of the second transistor (TR2) is constituted of the surface region of the third region (SC3) constituting the channel forming region (CH1) of the first transistor (TR1),
(B-3) a channel forming region (CH2) of the second transistor (TR2) is constituted of the surface region of the first region (SC1) constituting the other source/drain region of the first transistor (TR1),
(C-1) gate regions of the junction-field-effect transistor (TR3) are constituted of the fifth region (SC5) and a portion of the third region (SC3) facing the fifth region (SC5),
(C-2) a channel region (CH3) of the junction-field-effect transistor (TR3) is constituted of part of the fourth region (SC4) sandwiched by the fifth region (SC5) and said portion of the third region (SC3),
(C-3) one source/drain region of the junction-field-effect transistor (TR3) is constituted of a portion of the fourth region (SC4) extending from one end of the channel region (CH3) of the junction-field-effect transistor (TR3) and constituting one source/drain region of the first transistor (TR1),
(C-4) the other source/drain region of the junction-field-effect transistor (TR3) is constituted of a portion of the fourth region (SC4) extending from the other end of the channel region (CH3) of the junction-field-effect transistor (TR3),
(D) the gate portion (G) is connected to a first memory-cell-selecting line,
(E) a diode (D) is formed between the first region (SC1) and the second region (SC2), and the first region (SC1) is connected to a write-in information setting line through the diode (D),
(F) the second region (SC2) is connected to the write-in information setting line,
(G) the portion of the fourth region (SC4) constituting the other source/drain region of the junction-field-effect transistor (TR3) is connected to a second memory-cell-selecting line, and
(H) the fifth region (SC5) is connected to a predetermined potential line.

2. The semiconductor memory cell according to claim 1, wherein the semiconductor memory cell is formed in a well having the first conductivity type.

3. The semiconductor memory cell according to claim 1, wherein the semiconductor memory cell is formed on an insulator.

## Patentansprüche

1. Halbleiterspeicherzelle, aufweisend einen ersten Transistor (TR1) eines ersten Leitfähigkeitstyps zum Auslesen, einen zweiten Transistor (TR2) eines zweiten Leitfähigkeitstyps zum Einschreiben und einen Sperrschicht-Feldeffekttransistor (TR3) des ersten Leitfähigkeitstyps zum laufenden Steuern, wobei
die Halbleiterspeicherzelle aufweist:
1) ein erstes halbleitendes Gebiet (SC1) des ersten Leitfähigkeitstyps
2) ein zweites halbleitendes oder leitendes Gebiet (SC2), das in einem Oberflächengebiet der ersten Gebiets (SC1) ausgebildet ist, wobei das zweite Gebiet (SC2) zusammen mit dem ersten Gebiet (SC1) einen Gleichrichterübergang bildet,
3) ein drittes halbleitendes Gebiet (SC3) des zweiten Leitfähigkeitstyps, das in einem Oberflächengebiet des ersten Gebiets (SC1) ausgebildet ist und vom zweiten Gebiet (SC2) räumlich getrennt ist,
4) ein viertes halbleitendes Gebiet (SC4) des ersten Leitfähigkeitstyps, das in einem Oberflächengebiet des dritten Gebiets (SC3) ausgebildet ist,
5) ein fünftes halbleitendes oder leitendes Gebiet (SC5), das in einem Oberflächengebiet des vierten Gebiets (SC4) ausgebildet ist, wobei das fünfte Gebiet (SC5) zusammen mit dem vierten Gebiet (SC4) einen Gleichrichterübergang bildet,
6) einen Gateabschnitt (G), der vom ersten Transistor (TR1) und zweiten Transistor (TR2) gemeinsam benutzt ist und auf einer Barriereschicht ausgebildet ist, um das erste Gebiet (SC1) und das vierte Gebiet (SC4) zu überbrücken und um das zweite Gebiet (SC2) und das dritte Gebiet (SC3) zu überbrücken,
wobei
A-1) ein Source/Drain-Gebiet des ersten Transistors (TR1) aus dem Oberflächengebiet des vierten Gebiets (SC4) gebildet ist,
A-2) das andere Source/Drain-Gebiet des ersten Transistors (TR1) aus dem Oberflächengebiet des zwischen dem zweiten Gebiet (SC2) und dem dritten Gebiet (SC3) angeordneten ersten Gebiet (SC1) gebildet ist,
A-3) ein Kanalbildungsgebiet (CH1) des ersten Transistors (TR1) aus dem zwischen dem Oberflächengebiet des ersten Gebiets (SC1) und dem Oberflächengebiet des vierten Gebiets angeordneten Oberflächengebiet des dritten Gebiets (SC3) gebildet ist,
B-1) ein Source/Drain-Gebiet des zweiten Transistors (TR2) aus dem zweiten Gebiet (SC2) gebildet ist,
B-2) das andere Source/Drain-Gebiet des zweiten Transistors (TR2) aus dem das Kanalbildungsgebiet (CH1) des ersten Transistors (TR1) bildenden Oberflächengebiet des dritten Gebiets (SC3) gebildet ist,
B-3) ein Kanalbildungsgebiet (CH2) des zweiten Transistors (TR2) aus dem das andere Source/Drain-Gebiet des ersten Transistors (TR1) bildenden Oberflächengebiet des ersten Gebiets (SC1) gebildet ist,
C-1) Gategebiete des Sperrschicht-Feldeffekttransistors (TR3) aus dem fünften Gebiet (SC5) und einem dem fünften Gebiet (SC5) gegenüberliegenden Abschnitt des dritten Gebiets (SC3) gebildet sind,
C-2) ein Kanalgebiet (CH3) des Sperrschicht-Feldeffekttransistors (TR3) aus einem zwischen dem fünften Gebiet (SC5) und dem genannten Abschnitt des dritten Gebiets (SC3) angeordneten Teil des vierten Gebiets (SC4) gebildet ist,
C-3) ein Source/Drain-Gebiet des Sperrschicht-Feldeffekttransistors (TR3) aus einem sich von einem Ende des Kanalgebiets (CH3) des Sperrschicht-Feldeffekttransistors (TR3) erstreckenden und ein Source/Drain-Gebiet des ersten Transistors (TR1) bildenden Abschnitt des vierten Gebiets (SC4) gebildet ist,
C-4) das andere Source/Drain-Gebiet des Sperrschicht-Feldeffekttransistors (TR3) aus einem sich vom anderen Ende des Kanalgebiets (CH3) des Sperrschicht-Feldeffekttransistors (TR3) erstreckenden Abschnitt des vierten Gebiets (SC4) gebildet ist,
D) der Gateabschnitt (G) mit einer ersten Speicherzellenauswahlleitung verbunden ist,
E) eine Diode (D) zwischen dem ersten Gebiet (SC1) und dem zweiten Gebiet (SC2) gebildet ist und das erste Gebiet (SC1) mit einer Einschreibinformations-Einstellungsleitung durch die Diode (D) verbunden ist,
F) das zweite Gebiet (SC2) mit der Einschreibinformations-Einstellungsleitung verbunden ist,
G) der das andere Source/Drain-Gebiet des Sperrschicht-Feldeffekttransistors (TR3) bildende Abschnitt des vierten Gebiets (SC4) mit einer zweiten Speicherzellenauswahlleitung verbunden ist, und
H) das fünfte Gebiet (SC5) mit einer vorbestimmten Potentialleitung verbunden ist.

2. Halbleiterspeicherzelle nach Anspruch 1, wobei die Halbleiterspeicherzelle in einer den ersten Leitfähigkeitstyp aufweisenden Vertiefung ausgebildet ist.

3. Halbleiterspeicherzelle nach Anspruch 1, wobei die Halbleiterspeicherzelle auf einem Isolator ausgebildet ist.

## Revendications

1. Cellule mémoire à semi-conducteurs comprenant un premier transistor (TR₁) d'un premier type de conductivité pour la lecture, un deuxième transistor (TR₂) d'un deuxième type de conductivité pour l'écriture, et un transistor à effet de champ à jonction (TR₃) du premier type de conductivité pour la commande du courant,
ladite cellule mémoire à semi-conducteurs ayant :
(1) une première région semi-conductrice (SC₁) du premier type de conductivité,
(2) une deuxième région semi-conductrice (SC₂) ou conductrice formée dans une région de surface de la première région (SC₁), ladite deuxième région (SC₂) formant une jonction redresseuse avec la première région (SC₁),
(3) une troisième région semi-conductrice (SC₃) du deuxième type de conductivité formée sur une région de surface de la première région (SC₁) et espacée de la deuxième région (SC₂),
(4) une quatrième région semi-conductrice (SC₄) du premier type de conductivité formée dans une région de surface de la troisième région (SC₃),
(5) une cinquième région semi-conductrice (SC₅) ou conductrice formée dans une région de surface de la quatrième région (SC₄), ladite cinquième région (SC₅) formant une jonction redresseuse avec la quatrième région (SC₄), et
(6) une portion formant grille (G) partagée par le premier transistor (TR₁) et le deuxième transistor (TR₂ et formée sur une couche barrière de façon à former un pont entre la première région (SC₁) et la quatrième région (SC₄) et à former un pont entre la deuxième région (SC₂) et la troisième région (SC₃),
dans laquelle :
(A-1) une région de source/drain du premier transistor (TR₁) est constituée de la région de surface de la quatrième région (SC₄),
(A-2) l'autre région de source/drain du premier transistor (TR₁) est constituée de la région de surface de la première région (SC₁) prise en sandwich entre la deuxième région (SC₂) et la troisième région (SC₃),
(A-3) une région formant canal (CH₁) du premier transistor (TR₁) est constituée de la région de surface de la troisième région (SC₃) prise en sandwich entre la région de surface de la première région (SC₁) et la région de surface de la quatrième région,
(B-1) une région de source/drain du deuxième transistor (TR₂) est constituée de la deuxième région (SC₂),
(B-2) l'autre région de source/drain du deuxième transistor (TR₂) est constituée de la région de surface de la troisième région (SC₃) constituant la région formant canal (CH₁) du premier transistor (TR₁),
(B-3) une région formant canal (CH₂) du deuxième transistor (TR₂) est constituée de la région de surface de la première région (SC₁) constituant l'autre région de source/drain du premier transistor (TR₁),
(C-1) des régions de grille du transistor à effet de champ à jonction (TR₃) sont constituées de la cinquième région (SC₅) et d'une portion de la troisième région (SC₃) faisant face à la cinquième région (SC₅),
(C-2) une région de canal (CH₃) du transistor à effet de champ à jonction (TR₃) est constituée d'une partie de la quatrième région (SC₄) prise en sandwich entre la cinquième région (SC₅) et ladite portion de la troisième région (SC₃),
(C-3) une région de source/drain du transistor à effet de champ à jonction (TR₃) est constituée d'une portion de la quatrième région (SC₄) s'étendant à partir d'une extrémité de la région de canal (CH₃) du transistor à effet de champ à jonction (TR₃) et constituant une région de source/drain du premier transistor (TR₁),
(C-4) l'autre région de source/drain du transistor à effet de champ à jonction (TR₃) est constituée d'une portion de la quatrième région (SC₄) s'étendant à partir de l'autre extrémité de la région de canal (CH₃) du transistor à effet de champ à jonction (TR₃),
(D) la portion formant grille (G) est connectée à la première ligne de sélection de cellule mémoire,
(E) une diode (D) est formée entre la première région (SC₁) et la deuxième région (SC₂), la première région (SC₁) est connectée à une ligne de définition d'information d'écriture par l'intermédiaire de la diode (D),
(F) la deuxième région (SC₂) est connectée à la ligne de définition d'information d'écriture,
(G) la portion de la quatrième région (SC₄) constituant l'autre région de source/drain du transistor à effet de champ à jonction (TR₃) est connectée à une deuxième ligne de sélection de cellule mémoire, et
(H) la cinquième région (SC₅) est connectée à une ligne de potentiel prédéterminé.

2. Cellule mémoire à semi-conducteurs selon la revendication 1, laquelle cellule mémoire à semi-conducteurs est formée dans un puits ayant le premier type de conductivité.

3. Cellule mémoire à semi-conducteurs selon la revendication 1, laquelle cellule mémoire à semi-conducteurs est formée sur un isolant.
